# EUROPÄISCHE PATENTANMELDUNG

(11) **EP 0 639 662 A1**
(43) Veröffentlichungstag der Anmeldung: **22.02.1995**
(21) Anmeldenummer: 94111535.4
(22) Anmeldetag: 23.07.1994
(51) Int. Cl.: C30B 35/00, C30B 15/10

(54) **Tiegel, insbesondere Zweiteiliger Stütztiegel.**

(30) Priorität: 30.07.1993 DE 4325522
(71) Anmelder: Schunk Kohlenstofftechnik GmbH, D-35452 Heuchelheim (DE)
(72) Erfinder: Rauhut, Volker, D-35418 Buseck (DE)
(74) Vertreter: Stoffregen, Hans-Herbert, Dr. Dipl.-Phys.

(57) **Zusammenfassung**

Es wird ein Tiegel (12), insbesondere Stütztiegel für einen Quarztiegel (10) zum Ziehen von Siliciumeinkristallen vorgeschlagen, der aus einem Bodenteil (18) und einem Mantelteil (20) zusammengesetzt ist, die aus verschiedenen Materialien bestehen.

## Beschreibung

Die Erfindung bezieht sich auf einen Tiegel, insbesondere Stütztiegel für einen Quarztiegel zum Ziehen von Siliciumeinkristallen, wobei der Tiegel zumindest aus zwei Teilen lösbar zusammengesetzt ist und teilweise aus Graphit besteht.

Um Siliciumeinkristalle zu ziehen, wird Silicium zum Aufschmelzen in einen Quarztiegel eingebracht, der seinerseits von einem Stütztiegel aus Graphit aufgenommen wird. Der Stütztiegel wird von einer Heizung umgeben, die außenseitig von einem Schutzkörper abgeschirmt ist.

Bekannte Stütztiegel können ein- oder mehrteilig ausgebildet werden. Dabei hat sich eine dreiteilige Ausführungsform durchgesetzt, die sich aus jeweils um 120° des Tiegelumfangs erstreckende Segmente zusammensetzt. Diese bestehen aus Graphit, insbesondere Elektrographit, das mit herausspritzendem Silicium bzw. aus dem Quarztiegel abdampfendem SiO und SiO₂ Siliciumcarbid bildet, und zwar bevorzugterweise an der Kontaktfläche des Quarztiegels mit dem Graphitstütztiegel sowie den eine große Fläche zur Verfügung stellenden Spalten zwischen den einzelnen Segmenten.

Einhergehend mit der Bildung von Siliciumcarbid erfolgt eine Volumenzunahme des Stütztiegels mit der Folge einer Versprödung mit Rißbildung. Entsprechend ausgebildete Stütztiegel sind daher nur im geringen Umfang wiederverwendbar.

So können die gebräulichen 3-teiligen Tiegel nur ca. 40x verwendet werden. Der aufgenommene Quarztiegel hält nur einmal, da der Quarztiegel "weich" wird und sich an der Stütztiegelinnenwandung anlehnt. Der Quarztiegel läßt sich aufgrund der geteilten Ausführung aus dem Stütztiegel entnehmen.

Aus dem DE 40 07 053 C ist ein Graphittiegel bekannt, der aus mehreren Segmenten besteht und auf seiner Innenfläche, dem oberen Rand und an den Berührungsflächen der Segmente jeweils eine Schutzschicht aus in einem verbindenden Gerüst aus Kohlenstoff angeordneten gereckten Endloskohlenstoffasern aufweist. Auch wenn durch diese Maßnahmen die nachteilige und zur Volumenzunahme führende Siliciumcarbidbildung weitgehend vermieden werden kann, zeigen sich bei sehr dünnen Kohlenfaserstoffschichten Ablösungserscheinungen aufgrund einer Verzahnung mit den, von dem Stütztiegel aufgenommenen Quarztiegel. Unabhängig davon bereitet die Klebetechnik, um die Schutzschicht mit dem Graphitkörper zu verbinden, erhebliche Probleme.

Der vorliegenden Erfindung liegt die Aufgabe zugrunde, einen Tiegel der eingangs genannten Art so weiterzubilden, daß einerseits eine hohe Standzeit möglich ist und andererseits sichergestellt ist, daß weitgehend durch aus dem Quarztiegel herausspritzendes Silicium bzw. SiO- und SiO₂-Dämpfen eine mit einer Volumenzunahme verbundene Siliciumcarbidbildung unterbleibt.

Die Aufgabe wird erfindungsgemäß im wesentlichen dadurch gelöst, daß der Tiegel aus einem Bodenteil und einem Mantelteil zusammengesetzt ist, die aus verschiedenen Materialien bestehen, wobei das Material des Mantelteils weitgehend eine Siliciumcarbidbildung ausschließt.

Erfindungsgemäß wird ein zweiteiliger Tiegel vorgeschlagen, der aus dem vorzugsweise topfförmig ausgebildeten Bodenteil und dem die Form eines Hohlzylinders aufweisenden Mantelteil besteht. Durch diesen Aufbau bedingt werden die nach dem Stand der Technik bei mehrteiligen Graphittiegeln auftretenden Spalte zwischen den einzelnen Teilen weitgehend ausgeschlossen. Dadurch, daß das Mantelteil nur zu einer äußerst geringen Siliciumcarbidbildung neigt, können auch keine Volumenzunahmen auftreten.
Hierdurch wird eine Rißbildung weitestgehend vermieden.

Insbesondere ist vorgesehen, daß das topfförmig ausgebildete Bodenteil aus Graphit und das hohlzylinderförmige Mantelteil aus kohlenfaserstoffverstärktem Kohlenstoff (CFC) besteht.

Durch die Verwendung von CFC ergibt sich eine hohe Festigkeit bei gleichzeitiger Möglichkeit, eine Wandstärkenreduzierung vorzunehmen. Auch ist das Gewicht im Vergleich zu Graphit geringer, so daß man von einer Leichtbauweise sprechen kann.

Da das Mantelteil einheitlich aus CFC besteht, erübrigen sich die nach dem Stand der Technik erforderlichen Klebetechniken, so daß sich herstellungstechnische Vorteile ergeben.

Das Mantelteil ist vorzugsweise ein radial gewickelter CFC-Körper, der einfach herstellbar ist und in bezug auf Abmessungen kaum Grenzen setzt.

Das CFC-Material zeigt ferner den Vorteil eines guten Wärmeübergangs von der äußeren Heizung zu dem die Siliciumschmelze aufnehmenden Quarztiegel.

Auch wenn weitgehend ausgeschlossen ist, daß das aus insbesondere Elektrographit bestehende Bodenteil mit SiO bzw. SiO₂-Dämpfen oder aus dem Quarztiegel herausspritzendem Silicium in Berührung kommt, sollte das Mantelteil und das Bodenteil spaltfrei zusammengesetzt sein.

Besonders vorteilhaft ist es, wenn das Bodenteil mit seiner Innenfläche bündig in das Mantelteil übergeht. Dabei kann aufgrund der Materialeigenschaften des Mantelteils dessen Wandstärke im Stoßbereich Kleiner als die des Bodenteils sein.

Um einerseits ein sicheres spaltfreies Zusammensetzen zwischen Boden- und Mantelteil sicherzustellen und andererseits eine Selbstzentrierung vorzunehmen, sind eine Vielzahl von Möglichkeiten vorgesehen, die Stoßflächen zwischen Mantel- und Bodenteil auszubilden. So kann das Bodenteil in seiner Stirnfläche eine umlaufende Nut aufweisen, in der das Mantelteil eingesetzt ist. Ferner besteht die Möglichkeit, daß der Randbereich des Bodenteils eine umlaufende Stufe aufweist, an dessen Geometrie zumindest bereichsweise der zugewandte Randbereich des Mantelteils angepaßt ist. Auch ist die Möglichkeit gegeben, daß der Rand des Mantelteils einen umlaufenden Vorsprung aufweist, der in eine umlaufende Nut des Bodenteils eingreift.

Neben einer stumpfen Stoßfläche zwischen Mantelteil und Bodenteil kann auch eine schräg verlaufende Stoßfläche vorgesehen sein, die insbesondere eine Selbstzentrierung des Mantelteils zum Bodenteil ermöglicht.

In weiterer Ausgestaltung ist vorgesehen, daß das Mantelteil und/oder das Bodenteil mit SiC oder Pyrographit vorzugsweise durch CVD-Verfahren beschichtet sind.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung eines der Zeichnung zu entnehmenden bevorzugten Ausführungsbeispiels.

Es zeigen:

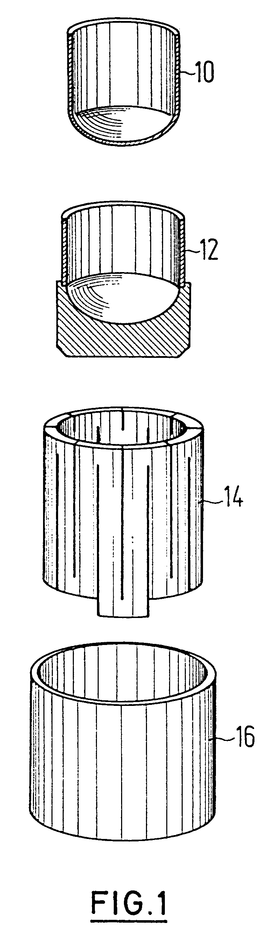

- Fig. 1: eine auseinandergezogene Darstellung einer Anordnung zum Ziehen von Siliciumeinkristallen,
- Fig. 2: in vergrößerter Darstellung einen Stütztiegel und
- Fig. 3: eine mögliche Ausführungsform des Ausschnitts III in Fig. 2.

Um Siliciumeinkristalle zu ziehen, wird Silicium in einem Quarztiegel aufgeschmolzen, der seinerseits in einen Stütztiegel (12) eingebracht und von diesem aufgenommen wird. Der Stütztiegel (12) wird seinerseits von einer Heizung (14) umgeben, die außenseitig von einer Strahlenabschirmung (16) abgeschirmt ist. Quarztiegel (10), Stütztiegel (12), Heizung (14) und Abschirmung (16) sind sodann koaxial ineinandergeschoben und bilden die gewünschte Anordnung zum Ziehen von Siliciumeinkristallen.

Der Stütztiegel (12) besteht erfindungsgemäß aus einem aus Elektrographit bestehenden Bodenteil (18) und einem aus kohlenfaserstoffverstärktem Kohlenstoff (CFC) bestehenden Mantelteil (20), deren Innenflächen (22) und (24) bündig ineinanderübergehend.

Das Bodenteil (18) weist eine Topfform auf. Das Mantelteil (20) stellt einen Hohlzylinder in Form eines radial gewickelten CFC-Körpers dar.

Der Stoßbereich (26) zwischen dem Mantelteil (20) und dem Bodenteil (22) ist vorzugsweise derart ausgebildet, daß einerseits eine Spaltfreiheit vorliegt und andererseits ein freier Durchgang zur Heizung (14) hin nicht möglich ist, so daß folglich zwischen dem Quarztiegel (10) und dem Stütztiegel (12) vagabundierende Dämpfe wie SiO oder SiO₂-Dämpfe nicht zur Heizung (14) gelangen können.

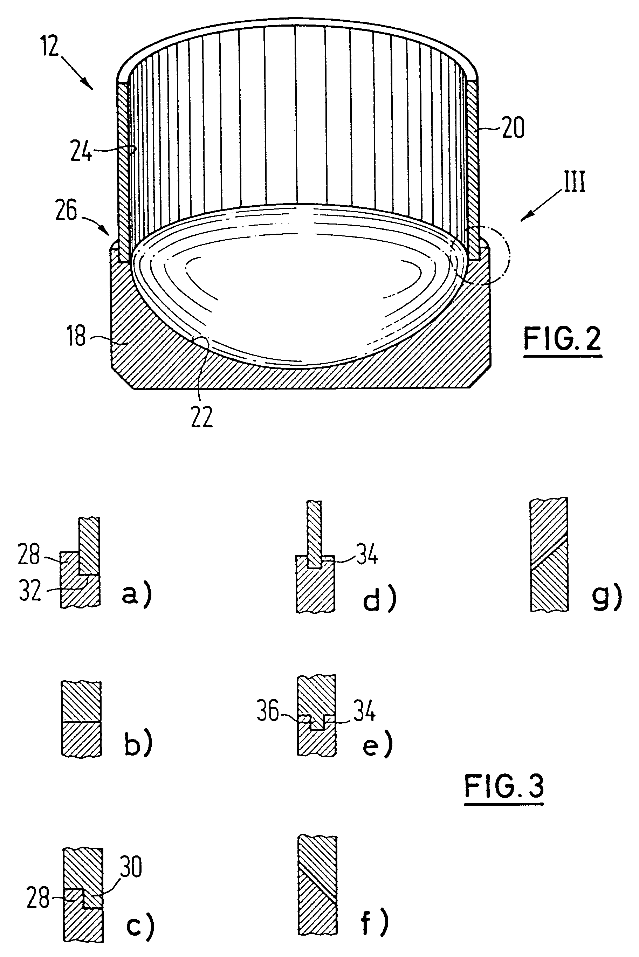

Verschiedene Ausbildungen des Stoßbereiches (26) sind der Fig. 3 zu entnehmen.

So kann das Bodenteil (18) einen als Stufe (28) ausgebildeten umlaufenden Rand aufweisen, auf den das Mantelteil (20) gesetzt ist. Dabei kann der zugewandte Rand (30) des Mantelteils (20) eine der Stufe (28) angepaßte Geometrie, also Stufe (30) (Fig. 3c) aufweisen oder sich entlang des inneren Absatzes (32) erstrecken, so daß die Wandstärke des Mantelteils (20) der Tiefe der Stufe (32) entspricht (Fig. 3a).

Auch besteht die Möglichkeit, das Mantelteil (20) und das Bodenteil (18) stumpf aufeinanderliegen zu lassen (Fig. 3b) oder über angeschrägte Randflächen (Fig. 3f und 3g), so daß sich eine Gehrung als Stoßfläche ergibt. Durch diese Maßnahme erfolgt auf einfache Weise eine Selbstzentrierung des Mantelteils (20) auf dem Bodenteil (18).

Den Fig. 3d und 3e sind weitere bevorzugte Alternativen zu entnehmen. So weist das Mantelteil (18) eine umlaufende Nut (34) auf, an die ein von dem Mantelteil (20) ausgehender, vorzugsweise umlaufender Vorsprung (36) eingreift (Fig. 3e) oder aber das Mantelteil (20) mit einer Wandstärke, die der Breite der Nut (34) entspricht, selbst eingesetzt ist.

Durch den erfindungsgemäß ausgebildeten Stütztiegel (12) ergibt sich der Vorteil, daß eine lange Wiederverwendbarkeit möglich ist. Eine Ausbildung von Siliciumcarbid ist weitgehend ausgeschlossen, so daß Volumenzunahmen nicht zu befürchten sind. Durch die Stoßausbildung zwischen dem Bodenteil (18) und dem Mantelteil (20) ist eine Spaltfreiheit gegeben, so daß weitgehend ausgeschlossen ist, daß sich im Wandbereich Siliciumcarbid ausbildet.

Zu erwähnen ist noch, daß das CFC-Mantelteil (20) zusammen mit dem Quarztiegel (10) ntfernt und anschließend der Quarztiegel (10) herausgedrückt wird. Hierbei wird der Quarztiegel (10) ohne Beschädigung des Mantelteils (20) zerstört.

## Patentansprüche

1. Tiegel (12), insbesondere Stütztiegel für einen Quarztiegel (10) zum Ziehen von Siliciumeinkristallen, wobei der Tiegel zumindest aus zwei Teilen (18, 20) lösbar zusammengesezt ist und teilweise aus Graphit besteht,
**dadurch gekennzeichnet,**
daß der Tiegel (12) aus einem Bodenteil (18) und einem Mantelteil (20) zusammengesetzt ist, die aus verschiedenen Materialien bestehen.

2. Tiegel nach Anspruch 1,
**dadurch gekennzeichnet**,
daß das topfförmig ausgebildete Bodenteil (18) aus Graphit und/oder das hohlzylinderförmige Mantelteil (20) aus kohlenfaserstoffverstärktem Kohlenstoff (CFC)-Material besteht oder dieses zumindest oberflächlich aufweist.

3. Tiegel nach Anspruch 2,
**dadurch gekennzeichnet**,
daß das Mantelteil (20) ein radial gewickelter CFC-Körper ist.

4. Tiegel nach zumindest einem der vorhergehenden Ansprüche,
**dadurch gekennzeichnet**,
daß das Bodenteil (18) mit seiner Innenfläche (22) bündig in das Mantelteil (20) übergeht, wobei vorzugsweise das Bodenteil im Stoßbereich (26) zum Mantelteil eine Wandstärke aufweist, die gleich oder größer als die des Mantelteils ist.

5. Tiegel nach zumindest einem der vorhergehenden Ansprüche,
**dadurch gekennzeichnet**,
daß das Mantelteil (20) und das Bodenteil (18) spaltfrei zusammengesetzt sind.

6. Tiegel nach zumindest einem der vorhergehenden Ansprüche,
**dadurch gekennzeichnet**,
daß das Bodenteil (18) in seiner Stirnfläche eine umlaufende Nut (34) aufweist, in der das Mantelteil (20) eingesetzt ist, wobei insbesonder das Mantelteil bodenseitig einen vorzugsweise umlaufenden Vorsprung (36) aufweist, der in die umlaufende Nut des Bodenteils eingreift.

7. Tiegel nach zumindest einem der vorhergehenden Ansprüche,
**dadurch gekennzeichnet**,
daß das Mantelteil (18) in seinem Randbereich eine umlaufende Stufe (28) aufweist, in die das Mantelteil (20) eingesetzt ist.

8. Tiegel nach zumindest Anspruch 7,
**dadurch gekennzeichnet**,
daß dem Bodenteil (18) zugewandter Rand (30) des Mantelteils (20) kongruent zur Stufe (28) des Bodenteils (18) ausgebildet ist.

9. Tiegel nach zumindest einem der vorhergehenden Ansprüche,
**dadurch gekennzeichnet**,
daß das Mantelteil (20) auf dem Bodenteil (18) in Gehrung oder stumpf aufsitzt.

10. Tiegel nach zumindest einem der vorhergehenden Ansprüche,
**dadurch gekennzeichnet**,
daß das Mantelteil (20) und/oder das Bodenteil (18) mit SiC oder Pyrographit beschichtet ist.
